(19) Europäisches Patentamt / European Patent Office / Office européen des brevets

(11) **EP 4 012 430 B1**

(12) **EUROPÄISCHE PATENTSCHRIFT**

(45) Veröffentlichungstag und Bekanntmachung des Hinweises auf die Patenterteilung:
**27.03.2024 Patentblatt 2024/13**

(21) Anmeldenummer: **21153092.8**

(22) Anmeldetag: **22.01.2021**

(51) Internationale Patentklassifikation (IPC):
**G01R 31/54** *(2020.01)* **G01R 31/58** *(2020.01)*

(52) Gemeinsame Patentklassifikation (CPC):
**G01R 31/54; G01R 31/58**

(54) **VERBINDUNGSPRÜFGERÄT UND VERFAHREN ZUM PRÜFEN EINER INTERMITTIERENDEN IMPEDANZÄNDERUNG**

CONNECTION TESTING DEVICE AND METHOD FOR TESTING INTERMITTENT IMPEDANCE CHANGE

APPAREIL DE TEST DE CONNEXION ET PROCÉDÉ DE TEST D'UN CHANGEMENT D'IMPÉDANCE INTERMITTENTE

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **11.12.2020 DE 102020133196**

(43) Veröffentlichungstag der Anmeldung:
**15.06.2022 Patentblatt 2022/24**

(73) Patentinhaber: WEETECH GmbH
**97877 Wertheim (DE)**

(72) Erfinder: **Hengl, Rudi**
**97877 Wertheim (DE)**

(74) Vertreter: **Gulde & Partner**
**Patent- und Rechtsanwaltskanzlei mbB**
**Wallstraße 58/59**
**10179 Berlin (DE)**

(56) Entgegenhaltungen:
**EP-A1- 1 560 349    CN-A- 103 983 884**
**US-A- 5 744 967    US-A1- 2019 257 882**
**US-A1- 2019 383 873**

EP 4 012 430 B1

**Beschreibung**

TECHNISCHES GEBIET

Die vorliegende Erfindung betrifft ein Verbindungsprüfgerät und ein Verfahren zum Prüfen einer intermittierenden Impedanzänderung in einer ersten und/oder zweiten Leitung.

STAND DER TECHNIK

Fertig konfektionierte Kabelbäume mit Verbindungssteckern, vor allem mit vielen Einzelleitern bzw. Leiternetzwerken, werden in der Herstellung und Instandhaltung üblicherweise mit automatisierten Verbindungstestern überprüft.

Herkömmliche Verbindungstester prüfen, ob die Verbindung in einem Einzelleiter oder Verbindungen in Leiternetzwerken, die mehrere Einzelleiter umfassen, niederohmig mit Steckkontakten der Verbindungsstecker verbunden sind. Ferner können solche Verbindungstester prüfen, ob die Isolation zwischen nicht miteinander verbundenen Einzelleitern hochohmig ist.

Diese Verbindungstester werden meist von einem Programm gesteuert. Das Programm steuert einen Prüfablauf und protokolliert die Prüfung und Prüfergebnisse. Das Programm ist normalerweise auf den zu prüfenden Kabelbaum und Verbindungsdaten des Kabelbaums angepasst. Teilweise kann der Prüfablauf direkt aus Bauplänen der Kabelbäume erzeugt werden.

In einem Kabelbaum mit vielen Einzelleitern sind zahlreiche Verbindungen zu prüfen. Manuelles Prüfen und Protokollieren von Kabelbäumen ist fehleranfällig und zeitaufwendig und daher selten geworden.

Aus der GB 2 529 456 A ist ein Tester zum Erkennen von intermittierenden Fehlern in Leitungen sowie ein Simulationssystem für solche intermittierenden Fehler bekannt. Das Simulationssystem erzeugt Widerstandsänderungen, um mehrere Testkanäle des Testers zu prüfen.

Aus der GB 2 531 268 A ist ein System zur Überwachung und Anzeige eines Zustands eines Prüfgeräts für intermittierende Fehler bekannt.

Die US 2010/268507 A1 beschreibt ein Verfahren und eine Vorrichtung zum Detektieren von Fehlern in Mehrleiterverdrahtungen für elektronische Systeme. Die Vorrichtung kann konstante und intermittierende Fehler erkennen; sie umfasst mehrere Eingänge, die mit verschiedenen Testpunkten im Prüfling verbunden werden können, ein Schaltmodul mit mehreren Multiplexern und ein Multimeter, das über die Multiplexer mit den verschiedenen Testpunkten verbunden werden kann. Eine ähnliche Vorrichtung ist auch aus der US 5744967 A bekannt.

Aus der WO 2020/125996 A1 ist ein Verfahren und eine Vorrichtung zum Prüfen eines Kabelsatzes mit einer Anzahl von Netzwerken bekannt. Die Netzwerke umfassen dabei eine Anzahl elektrischer Baugruppen. Dieses bekannte Verfahren umfasst ein Beaufschlagen der Netzwerke mit einem Wechselspannungssignal, ein Messen des Stroms und der Spannung für jedes der mit dem Wechselspannungssignal beaufschlagten Netzwerke, ein Vergleichen von basierend auf dem jeweils gemessenen Strom und der jeweils gemessenen Spannung erstellten Spannungs-Strom-Kennlinien der jeweiligen Netzwerke mit einer vorgegebenen Soll-Spannungs-Strom-Kennlinie für das jeweilige Netzwerk, und ein Ausgeben einer Fehlermeldung, wenn eine der basierend auf dem jeweils gemessenen Strom und der jeweils gemessenen Spannung erstellten Spannungs-Strom-Kennlinien von der entsprechenden Soll-Spannungs-Strom-Kennlinie um mehr als einen vorgegebenen Schwellwert abweicht.

Aus der US 2019257882 A1 ist eine Prüfvorrichtung zum Identifizieren von Unterbrechungsfehlern in einer zu prüfenden Einheit bekannt. Die Prüfvorrichtung umfasst eine Schnittstelle zum elektrischen Verbinden mindestens einer zu prüfenden Einheit mit einem oder mehreren Prüfmodulen. Jede zu prüfende Einheit hat mehrere Verbindungleitungen, die zum Verbinden elektronischer Komponenten konfiguriert sind. Die Prüfvorrichtung umfasst desweiteren eine Eingangsschaltung zum Bereitstellen eines individuelles Stimulussignals für jeden nicht mit Strom versorgten Verbindungspunkt in der zu prüfenden Einheit. Die Prüfvorrichtung umfasst ferner eine aktive Unterbrechungserkennungsschaltung, die elektronisch mit jedem Verbindungspunkt in der zu prüfenden Einheit verbunden ist. Das Stimulussignal wird an jede Verbindungsleitung angelegt, sodass ein Unterbrechungsfehler auf einer beliebigen Leitung einen Trigger auf denjenigen Verbindungsleitungen erzeugt, die einen Unterbrechungsfehler aufweisen. Die Prüfvorrichtung umfasst auch eine Logikschaltung, die so konfiguriert ist, dass sie folgende Verfahrensschritte ausführt. Bestimmen, wann ein Trigger auf der zu prüfenden Einheit erzeugt wurde. Bestimmen des Verbindungspunktes des Triggers auf der zu prüfenden Einheit. Zuordnen eines Zeitstempels zu dem identifizierten Unterbrechungsfehler und Erzeugen eines Datenpakets, das dem Unterbrechungsfehler entspricht, zur Meldung an ein steuerndes Computersystem.

Aus der CN 103983884 A ist eine Vorrichtung zum Testen von mehradrigen Kabeln bekannt. Diese bekannte Vorrichtung vergleicht insbesondere ein Signal von einem zu testenden Kabel mit einem Signal eines funktionierenden Kabels.

Aus der US 2019383873 A1 ist eine Vorrichtung zum Testen von Kommunikationsverbindungen bekannt, die Analog-Digital-Wandler und Digital-Analog-Wandler umfasst.

AUFGABE

Somit besteht die Aufgabe der Erfindung darin ein Verbindungsprüfgerät bereitzustellen, das dynamische Leitungsfehler in Form von intermittierenden Impedanzänderungen in einzelnen Leitungen aber auch in Kabelbäumen mit vielen Leitungen gleichzeitig und dadurch schnell prüft, d.h. die Prüfzeit verkürzt, und das zugleich kostengünstig, insbesondere ohne teure Präzisionsmessgeräte und ohne Schaltmatrizen oder Multiplexer herstellbar ist.

OFFENBARUNG DER ERFINDUNG

Erfindungsgemäß wird ein Verbindungsprüfgerät zum Prüfen einer intermittierenden Impedanzänderung in einer ersten und/oder zweiten Leitung gemäß Anspruch 1, sowie ein Verfahren zum Prüfen einer intermittierenden Impedanzänderung in einer ersten und/oder zweiten Leitung gemäß Anspruch 13, bereitgestellt.
Der Begriff "Prüfen" soll im Wesentlichen die Bedeutung umfassen die erste Leitung auf Fehlerfreiheit zu überprüfen. Die Fehlerfreiheit kann als "vorhanden" oder "nicht vorhanden" oder konkreterer als "intermittierende Impedanzänderung liegt vor" oder intermittierende Impedanzänderung liegt nicht vor" oder noch konkreter als "Unterbrechung liegt vor" oder "Unterbrechung liegt nicht vor" oder "Kurzschluss liegt vor" oder "Kurzschluss liegt nicht vor" ausgedrückt werden. Der Begriff "Prüfen" kann im Unterschied zum Begriff "Messen" nicht die Bedeutung umfassen, dass ein genauer Messwert ermittelt wird. Der Begriff "Prüfen" kann die Bedeutung von "Testen" oder von "Ermitteln" umfassen.
Der Begriff "verbunden" kann die Bedeutung "gekoppelt" umfassen. Insbesondere wird unter "verbunden" "elektrisch verbunden", "elektrisch leitend verbunden" oder "elektrisch gekoppelt" verstanden. Zwei verbundene Elemente der Erfindung, also etwa die Auswertelogik und die Empfängereingangsschaltung, sollen insbesondere auch bei dazwischengeschalteten Elementen, wie Stecker, Schalter, Filter oder ähnliches, als miteinander verbunden gelten.
Der Begriff "Impedanz" soll insbesondere die Bedeutungen "Wechselstromwiderstand"; $Z = R + jX$, wobei R ein Realteil der Impedanz und X ein Imaginärteil der Impedanz ist; $Z = |Z| * e^{j\varphi}$, wobei $|Z|$ der Scheinwiderstand und $\varphi$ ein Phasenverschiebungswinkel mit Werten zwischen -90° und 90° ist; "Scheinwiderstand" und/oder "reeller Widerstand" umfassen.
Der Begriff "intermittierend" kann die Bedeutungen "zeitweilig aussetzend", "nachlassend", "mit Unterbrechung", "zeitlichen Zwischenräumen erfolgend" und/oder "verlaufend" umfassen.
Die erste und die zweite Leitung bzw. der erste Leiter und der zweite Leiter umfassen jeweils im Wesentlichen ein erstes Leitungsende und ein zweites Leitungsende. Die erste und die zweite Leitung können je ein Leitungsnetzwerk umfassen, wobei mehrere erste und/oder zweite Leitungsenden vorliegen. Die erste und die zweite Leitung können Steckverbinder umfassen, wobei insbesondere am ersten Leitungsende ein erster Steckverbinder und/oder am zweiten Leitungsende ein zweiter Steckverbinder verbunden ist. Der erste Testpunkt kann mit dem ersten Leitungsende oder mit dem ersten Steckverbinder der ersten oder zweiten Leitung verbunden sein. Der zweite Testpunkt kann mit dem zweiten Leitungsende oder mit dem zweiten Steckverbinder der ersten oder zweiten Leitung verbunden sein. Die erste und die zweite Leitung weisen jeweils im Allgemeinen zwischen erstem und zweiten Leitungsende eine Impedanz auf. Ferner können die erste und zweite Leitung jeweils einen Isolationsmantel umfassen. Leitungen mit Isolationsmantel können als Kabel bezeichnet werden. Mehrere Kabel können zusammen einen Kabelbaum bilden.
Die Impedanz kann sich durch verschiedene Ursachen verändern. Zu den Ursachen gehören eine fehlerhafte Lötstelle, eine kalte Lötstelle, eine fehlerhafte Crimpverbindung an einem der Steckverbinder, Berührung nicht isolierter Stellen der ersten Leitung mit einer zweiten Leitung, Kabelbruch, Isolationsbeschädigung, eine unvollständig gesteckte Steckverbindung, ein Wackelkontakt etc. Impedanzänderungen, die bei bestimmten auf die erste Leitung einwirkenden Umwelteinflüssen auftreten, werden im Allgemeinen als vorübergehend, intermittierend oder dynamisch bezeichnet. Zu solchen bestimmten Umwelteinflüssen zählen etwa: Tieftemperatur (z.B. unter 77,4 K), Wärme, Licht, Feuchte, Wasser, Kondensation, Korrosion, Mechanische Beanspruchung (Schwingungen, Stöße, Erschütterungen, Beschleunigung), Meeresklima, Sand, Staub. Die erste und/oder zweite Leitung können, etwa mithilfe eines Prüfstands, einem künstlich erzeugten Umwelteinfluss ausgesetzt werden, um währenddessen auf Impedanzänderungen zu prüfen. So kann das erfindungsgemäße Verbindungsprüfgerät beispielsweise die Impedanz aller Leitungen eines mit Vibrationen beaufschlagen Kabelbaums gleichzeitig prüfen. Das Verbindungsprüfgerät kann einen Computer umfassen, der insbesondere an die Auswertelogik angeschlossen ist. Der Computer kann Daten über die Art und/oder Intensität des künstlich erzeugten Umwelteinflusses empfangen. Gemäß einer weiteren bevorzugten Ausbildung analysiert der Computer insbesondere Impedanzänderung bezüglich des künstlich erzeugten Umwelteinflusses. Der Computer kann so Zusammenhänge zwischen dem künstlich erzeugten Umwelteinfluss und der Impedanzänderung ermitteln.
Das Prüfsignal wird im Wesentlichen am ersten Leitungsende eingespeist und durch die Impedanz des ersten Leiters zu einem Empfangssignal am zweiten Leitungsende.
Herkömmliche Prüfvorrichtungen weisen meist nur ein einzelnes Messgerät auf, das über eine Schaltmatrix sequentiell mit mehreren Leitungen verbunden wird. Das erfindungsgemäße Verbindungsprüfgerät kann mehrere Sender und mehrere Empfänger umfassen um mehrere Leitungen parallel bzw. gleichzeitig und dadurch schnell zu prüfen.

Herkömmliche Prüfvorrichtungen setzen meist auf ein präzises und teures Multimeter oder Impedanzmessgerät. Das erfindungsgemäße Verbindungsprüfgerät kann ganz oder teilweise als IC, etwa als FPGA (englisch: Field Programmable Gate Array) oder ASIC (englisch application-specific integrated circuit) hergestellt sein. Dadurch ist das erfindungsgemäße Verbindungsprüfgerät kostengünstig herstellbar und kann schnell viele Leitungen prüfen.

Gemäß einer bevorzugten Ausführungsform umfasst die Empfängereingangsschaltung ein RC-Glied. Das RC-Glied kann ein Wechselspannungssignal vom zweiten Testpunkt abgreifen, wobei das Wechselspannungssignal im Wesentlichen das Eingangssignal bildet. R steht dabei im Allgemeinen für einen ohmschen Widerstand oder eine Abschlussimpedanz und C für einen Kondensator. Der Widerstand bzw. die Abschlussimpedanz und der Kondensator sind insbesondere parallel geschaltet. Ein zum zweiten Testpunkt und durch den Widerstand fließender Strom ruft am Widerstand insbesondere einen Spannungsabfall hervor. Der Kondensator sperrt einen Gleichspannungsanteil in dem Spannungsabfall und überträgt im Wesentlichen nur einen Wechselanteil, d.h. das Eingangssignal, des Spannungsabfalls zur Auswertelogik. Alternativ kann anstatt oder zusätzlich zum RC-Glied ein Übertrager oder Transformator eingesetzt werden.

In einer Weiterbildung der Erfindung kann die Auswertelogik wenigstens einen ersten Komparator umfassen, der das Eingangssignal mit einem einstellbaren ersten Schwellwert vergleicht. Eine Unterschreitung des ersten Schwellwerts kann eine Unterbrechung in der ersten oder zweiten Leitung bedeuten. Genauer gesagt, kann der erste Komparator das Wechselspannungssignal mit einem Spannungsschwellwert vergleichen. Unterschreitet das Wechselspannungssignal eine Mindestspannung bedeutet dies im Wesentlichen, dass der erste oder zweite Leiter und der Widerstand von weniger Strom durchflossen wird als erwartet. Dies kann eine vorübergehend erhöhte Impedanz in der ersten oder zweiten Leitung, d.h. eine Unterbrechung der ersten oder zweiten Leitung, bedeuten. Vorzugsweise gibt der erste Komparator ein binäres Vergleichsergebnis aus. Das binäre Vergleichsergebnis ist z.B. 0 für den Fall, dass das Wechselspannungssignal über dem Schwellwert liegt. Das binäre Vergleichsergebnis ist z.B. 1 für den Fall, dass das Wechselspannungssignal unter dem Schwellwert liegt. Das Vergleichsergebnis kann in einem Speicher gespeichert werden. Der Speicher kann mehrere Vergleichsergebnisse hintereinander abspeichern. Die Auswertelogik umfasst eine Uhr. Die Uhr kann als fortlaufender Zähler ausgebildet sein. Die mehreren Vergleichsergebnisse können jeweils mit einem von der Uhr erzeugten Zeitstempel im Speicher abgespeichert werden. Ein Summierer kann mehrere Vergleichsergebnisse aufsummieren, d.h. zählen, und im Speicher abspeichern. Der FPGA kann den Speicher und den Summierer umfassen.

Auch ein statischer Fehler ist in der ersten oder zweiten Leitung feststellbar, von einem dynamischen Fehler unterscheidbar und kann gezählt werden, etwa dann wenn der Fehler noch vorliegt, es ist aber seit einem vorangegangen Signalwechsel eine bestimmte, programmierbare Zeit vergangen.

Gemäß einer bevorzugten Ausgestaltung umfasst das Prüfsignal insbesondere eine Gleichspannung. Der erste oder zweite Leiter weist im Allgemeinen einen Leitungsbelag bzw. einen Leitungswellenwiderstand bzw. eine Impedanz auf. Die Impedanz kann sich durch die verschiedenen Ursachen und/oder Umwelteinflüsse verändern. Die an der ersten oder zweiten Leitung anliegende Gleichspannung ruft im Allgemeinen einen Gleichstrom in dem Leiter hervor. Tritt jedoch während der anliegenden Gleichspannung eine vorübergehende Impedanzänderung auf, so führt dies im Wesentlichen zu einer Stromänderung, die als Wechselkomponente bzw. Nicht-Gleichstromkomponente vom Empfänger auswertbar ist.

In einer vorteilhaften Weiterbildung umfasst der Prüfsignalgenerator einen Identifikationssignalgenerator, der ein eindeutiges Identifikationssignal erzeugt. Die Gleichspannung kann mit dem Identifikationssignal addiert oder moduliert werden und das Prüfsignal bilden. Das Identifikationssignal tritt vorzugsweise überlagert im Empfangssignal auf. Der Empfänger kann das Identifikationssignal dekodieren und dem Prüfsignal des Prüfsignalgenerators bzw. Senders zuordnen. Wenn das erfindungsgemäße Verbindungsprüfgerät mehrere Sender und Empfänger zum Prüfen mehrerer Leitungen umfasst, können die Empfänger anhand des Identifikationssignals die Empfangssignale jeweils den Prüfsignalen bestimmter Prüfsignalgeneratoren bzw. Sender zuordnen.

In einer weiteren Ausführungsform umfasst der Prüfsignalgenerator insbesondere einen Mischer und einen Oszillator, wobei der Mischer das Identifikationssignal mit einer vom Oszillator erzeugten Trägersignal zu einem, insbesondere BPSKmodulierten, Hochfrequenzsignal mischt. Insbesondere umfasst der Prüfsignalgenerator einen Basisbandgenerator zum Erzeugen eines eindeutigen Identifikationscodes; einen Non-Return-to-Zero (NRZ) Kodierer, der mit dem Basisbandgenerator verbunden ist und der den eindeutigen Identifikationscode in ein Wechselsignal bzw. NRZ-Signal kodiert; den Mischer, der mit dem NRZ Kodierer und dem Oszillator verbunden ist und der das NRZ-Signal und das Trägersignal empfängt und beide zu dem Hochfrequenzsignal mischt; einem Addierer, der die Gleichspannung und das Hochfrequenzsignal addiert, einem ersten Leistungsverstärker, der das Hochfrequenzsignal verstärkt, und einem ersten Schalter, der den ersten Leistungsverstärker wahlweise mit dem ersten Testpunkt verbinden kann und der das verstärkte Hochfrequenzsignal wahlweise zum ersten Testpunkt leitet, wobei das verstärkte Hochfrequenzsignal das Prüfsignal bildet.

Der Prüfsignalgenerator kann den Identifikationscode in einer Endlosschleife an den ersten Testpunkt ausgegeben.

Zusätzlich umfasst der Prüfsignalgenerator insbesondere einen zweiten Schalter, der das Hochfrequenzsignal und/oder den Basisbandgenerator deaktiviert, sodass der Prüfsignalgenerator nur das Gleichspannungssignal mit überlagertem Identifikationssignal bzw. nur das Gleichspannungssignal erzeugt, wobei das Gleichspannungssignal mit überlagertem Identifikationssignal oder das Gleichspannungssignal mittels des ersten Leistungsverstärkers verstärkt werden und wahlweise über den ersten Schalter als Prüfsignal zum ersten Testpunkt ausgegeben werden können. Das Gleichspannungssignal eignet sich insbesondere zum Prüfen, ob in der ersten oder zweiten Leitung eine Unterbrechung bzw. eine dynamische Impedanzerhöhung vorliegt.

Gemäß einer Weiterbildung umfasst der Empfänger insbesondere einen Identifikationssignal-Demodulator. Der Identifikationssignal-Demodulator kann einen Abwärtsmischer umfassen, der das Eingangssignal und das Trägersignal empfängt und das Eingangssignal um die Frequenz des Trägersignals zu einem Abwärtsmischerausgangssignal herabsetzt; einen Integrator, der mit dem Abwärtsmischer verbunden ist, das Abwärtsmischerausgangssignal empfängt, über eine Bitperiode integriert und als Integratorausgangssignal ausgibt; einen Schwellwertentscheider, der mit dem Integrator verbunden ist, das Integratorausgangssignal empfängt, in einer Bitmitte mit einem Entscheidungsschwellwert vergleicht und ein Digitalsignal ausgibt, und eine Basisband-Auswerteeinheit, die mit dem Schwellwertentscheider verbunden ist, das Digitalsignal empfängt und auswertet ob und gegebenenfalls welcher Identifikationscode im Digitalsignal enthalten ist. Die Basisband-Auswerteeinheit kann mittels des Identifikationscodes das Empfangssignal eindeutig dem Prüfsignal des Senders oder im Fall mehrerer Sender dem Prüfsignal eines bestimmten der mehreren Sender zuordnen.

Ferner kann der Empfänger ein Filter umfassen, das zwischen das RC-Glied und die Auswertelogik geschaltet ist. Das Filter kann das Identifikationssignal im Empfangssignal dämpfen. Das Filter umfasst beispielsweise ein Hochpassfilter, ein Bandbassfilter bzw. Basisbandfilter. Das Dämpfen kann verhindern, dass das Identifikationssignal zur Auswertelogik gelangt und dort zu einem fälschlichen Schwellwertvergleich führt. Das Filter kann parallel zu einem Bypass-Pfad geschaltet sein. Ein zweiter Schalter kann zwischen diese Parallelschaltung und dem RC-Glied geschaltet sein. Der zweite Schalter kann das Empfangssignal wahlweise zum Filter oder um das Filter herum in den Bypass-Pfad schalten. Ohne Filterung kann die Auswertelogik das Eingangssignal mit maximaler Bandbreite erhalten. Die maximale Bandbreite kann in den Fällen sinnvoll sein, in denen dem Eingangssignal kein Hochfrequenzsignal überlagert ist.

Zwischen die Parallelschaltung aus Bypass-Pfad und Filter sowie der Auswertelogik kann ein weiterer Leistungsverstärker geschaltet sein, der das Eingangssignal oder das gefilterte Eingangssignal verstärkt und es als verstärktes Eingangssignal der Auswertelogik zuführt.

Das Identifikationssignal ist insbesondere mit einem digitalen Modulationsverfahren moduliert, z.B. Phasenumtastung (englisch: Phase-Shift Keying, PSK), BPSK oder 2-PSK. Der Sender insbesondere einen BPSK-Modulator, der das Identifikationssignal erzeugt, und der Empfänger kann einen BPSK-Demodulator umfassen, der das Identifikationssignal dekodiert. BPSK-Modulatoren und BPSK-Demodulatoren sind im Allgemeinen einfach herzustellen, da sie in einem FPGA implementiert werden können und für eine Analogsignalwandlung normalerweise keine teuren Analog-Digital-Wandler oder Digital-Analog-Wandler erforderlich sind.

In einer weiteren Ausgestaltung kann eine Frequenz des Trägersignals in Abhängigkeit einer Länge der ersten oder zweiten Leitung gewählt sein. Insbesondere ist die Frequenz des Trägersignal umgekehrt proportional zur Länge der ersten oder zweiten Leitung gewählt. Noch bevorzugter soll gelten:

$$\lambda = VK \cdot \frac{c_0}{f_c} \gg 2 \cdot L$$

wobei

$\lambda$: Wellenlänge der Frequenz des Trägersignals
VK: Verkürzungsfaktor der ersten Leitung, z.B. 0,66
$c_0$: Lichtgeschwindigkeit in Vakuum
$f_c$: Frequenz des Trägersignals
L: maximale Länge der ersten Leitung

Dies bewirkt im Wesentlichen, dass die mit einem Hochfrequenzsignal beaufschlagte erste Leitung nicht als Antenne wirkt und in die zweite Leitungen oder in das Verbindungsprüfgerät einstrahlt.

Gemäß einer bevorzugten Weiterbildung kann der Prüfsignalgenerator das Hochfrequenzsignal mit der Gleichspannung summieren und daraus das Prüfsignal bilden. So entsteht im Wesentlichen eine modulierte Gleichspannung. Die modulierte Gleichspannung kann mittels des Leistungsverstärkers verstärkt und über den ersten Testpunkt an die erste Leitung ausgegeben werden.

Des Weiteren ist es bevorzugt, dass der Sender den ersten Schalter umfasst, der den Prüfsignalgenerator vom ersten Testpunkt wahlweise entkoppeln kann. Insbesondere sind der Sender, der Empfänger vollständig oder teilweise in einem Chip implementiert und bilden zusammen einen Sendeempfänger. Der Begriff Testpunkt kann dabei die Bedeutung eines Anschlussinterfaces für ein Leitungsende umfassen und/oder gleichbedeutend zum ganzen Sendempfänger verstanden werden. Der erste Schalter kann steuern, ob der Sendeempfänger als kombinierter Sender und Empfänger oder als Empfänger konfiguriert ist. Das Verbindungsprüfgerät umfasst beispielsweise wenigstens zwei Sendeempfänger, wobei einer als Sender und der andere als Empfänger konfiguriert ist. Bevorzugt sind 10, 100, 1.000, 10.000 oder 100.000 Sendeempfänger in dem Chip implementierbar, um mehrere Leitungen parallel bzw. gleichzeitig prüfen zu können.

Gemäß einer bevorzugten Weiterbildung kann das Verbindungsprüfgerät einen zweiten Empfänger zum Prüfen der ersten und/oder zweiten Leitung umfassen. Insbesondere in einem Kabelbaum kann es durch die verschiedenen Ursachen und die einwirkenden Umwelteinflüsse zu einem vorübergehenden Kurzschluss zwischen zwei Kabeln oder Leitungen des Kabelbaums kommen. Auch in Steckverbindern am Kabelbaum können vorübergehende Kurzschlüsse auftreten. Das erfindungsgemäße Verbindungsprüfgerät kann neben vorübergehenden Unterbrechungen auch vorübergehende Kurzschlüsse feststellen. Dazu umfasst die Auswertelogik insbesondere einen zweiten Komparator, der das Eingangssignal mit einem zweiten Schwellwert vergleicht, wobei eine Überschreitung des zweiten Schwellwerts einen Kurzschluss zwischen der ersten und zweiten Leitung bedeuten kann. Vorzugsweise ist der erste Schwellwert kleiner als der zweite Schwellwert. Der erste und zweite Schwellwert bilden im Wesentlichen eine untere und eine oberen Schwellenspannung. Eine Differenz zwischen dem ersten und zweiten Schwellenspannung kann zusammen mit einer Eingangsverstärkung die Ansprechempfindlichkeit der Komparatoren definieren. Die Ansprechempfindlichkeit kann einen messbaren Impedanzänderungsbereich definieren. Vorzugsweise liegt eine Nennimpedanz der ersten und/oder zweiten Leitung in der Mitte zwischen dem ersten und zweiten Schwellwert. Die Schwellenspannungen sind einstellbar und umfassen im Wesentlichen einen Zielwert und einen Toleranzwert. Mittels des bekannten Widerstandes im RC-Glied und der unteren und der oberen Schwellenspannung kann die Auswertelogik eine Erhöhung der Impedanz der ersten Leitung über eine obere Impedanzgrenze oder eine Verringerung der Impedanz der ersten Leitung unter eine untere Impedanzgrenze feststellen. Im Fall eines vorübergehenden Kurzschlusses im Kabelbaum tritt dabei im Allgemeinen ein Differenz-Signalpegel zwischen der ersten und der zweiten Leitung auf, der je nach Polarität eine Stromerhöhung am Widerstand des ersten Empfängers oder an einem Widerstand des zweiten Empfängers hervorruft. Die Stromerhöhung ruft eine Spannungserhöhung hervor, die wiederum zu einem Überschreiten der oberen Schwellenspannung führen kann. Durch das Identifikationssignal kann der Empfänger feststellen von welchem Sender es stammt. Ist bekannt welcher Sender mit welchem Kabel des Kabelbaums verbunden ist so kann festgestellt werden, welche Kabel vorübergehend kurzgeschlossen sind. Das BPSK-Modulieren des Hochfrequenzssignals ist inbesondere für das Prüfen eines Kurzschlusses zwischen der ersten und der zweiten Leitung von Vorteil. Das BPSK-Modulieren vermeidet beispielsweise eine Signalpegelgleichheit auf der ersten und zweiten Leitung sowie die Gleichheit einer Signalpegelverteilung über die erste und zweite Leitung. Sind die Signalpegel und die Signalpegelverteilung über die erste und zweite Leitung nicht gleich, so kann sich ein detektierbarer Differenzsignalpegel bilden.

Vorteilhafte Weiterbildungen der Erfindung sind in den Unteransprüchen angegeben und in der Beschreibung beschrieben.

KURZBESCHREIBUNG DER ZEICHNUNGEN

Ausführungsbeispiele der Erfindung werden anhand der Zeichnungen und der nachfolgenden Beschreibung näher erläutert. Es zeigen:

Figur 1 ein Blockdiagramm eines Verbindungsprüfgeräts gemäß eines Ausführungsbeispiels der Erfindung,
Figur 2 ein Prüfverfahren gemäß eines Ausführungsbeispiels der Erfindung,
Figur 3A ein Blockdiagramm eines Verbindungsprüfgeräts gemäß eines weiteren Ausführungsbeispiels der Erfindung,
Figur 3B eine Anwendung des Verbindungsprüfgeräts gemäß des weiteren Ausführungsbeispiels der Erfindung und
Figur 3C eine Anwendung des Verbindungsprüfgeräts gemäß des weiteren Ausführungsbeispiels der Erfindung.

AUSFÜHRUNGSFORMEN DER ERFINDUNG

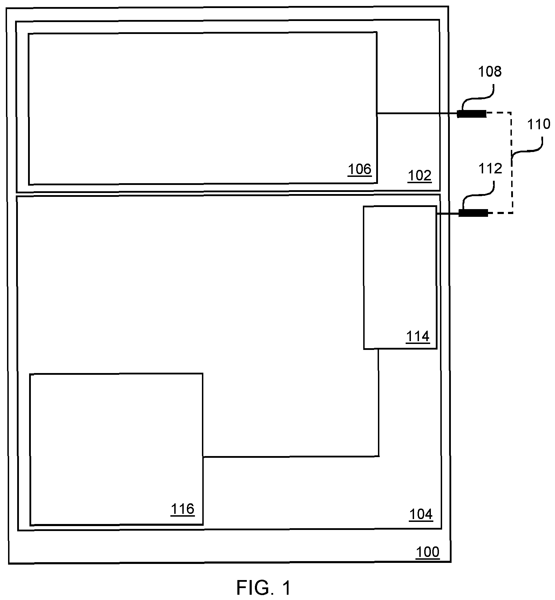

In der Figur 1 ist ein Verbindungsprüfgerät 100 gemäß eines Ausführungsbeispiels der Erfindung gezeigt. Das Verbindungsprüfgerät 100 umfasst einen Sender 102 und einen Empfänger 104. Der Sender 102 umfasst einen Prüfsignalgenerator 106, der ein Prüfsignal erzeugt. Ferner umfasst der Sender 102 einen ersten Testpunkt 108 zum Anschluss eines ersten Leitungsendes einer ersten Leitung 110. Der Prüfsignalgenerator 106 führt das Prüfsignal über den ersten Testpunkt 108 der ersten Leitung 110 zu. Der Sender 102 kann zusammen mit einem weiteren Empfänger einen Sendeempfänger bzw. einen Testpunkt bilden. Der Empfänger 104 umfasst einen zweiten Testpunkt 112 zum Anschluss eines zweiten Leitungsendes der ersten Leitung 110. Ferner umfasst der Empfänger 104 eine Empfängereingangsschaltung 114, die über den zweiten Testpunkt 112 ein Empfangssignal aus der ersten Leitung empfängt, und eine Auswertelogik 116, die mit der Empfängereingangsschaltung 114 verbunden ist. Der Empfänger 104 kann zusammen mit einem weiteren Sender einen weiteren Sendempfänger bzw. einen weiteren Testpunkt bilden.

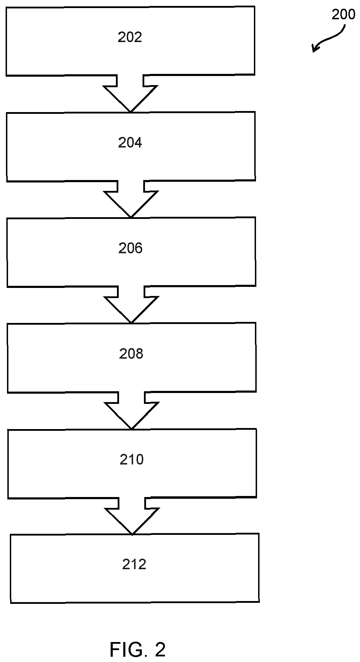

In der Figur 2 ist ein Prüfverfahren 200 zum Prüfen einer intermittierenden Impedanzänderung in einer ersten und/oder zweiten Leitung gezeigt. In einem ersten Schritt 202 sendet ein Sender ein Prüfsignal in ein erstes Leitungsende der ersten oder zweiten Leitung. In einem zweiten Schritt 204 wird der erste und/oder zweite Leiter Umwelteinflüssen ausgesetzt, z.B.: Tieftemperatur (unter 77,4 K), Wärme, Licht, Feuchte, Wasser, Kondensation, Korrosion, Mechanische Beanspruchung (Schwingungen, Stöße, Erschütterungen, Beschleunigung), Meeresklima, Sand und/oder Staub. Die Umwelteinflüsse führen zu einer dynamischen Änderung einer Impedanz der ersten und/oder zweiten Leitung. In einem dritten Schritt 206 empfängt ein Empfänger ein Eingangsstromsignal das auf dem durch Impedanzänderung geänderten Gleichspannungssignal basiert von einem zweiten Leitungsende der ersten oder zweiten Leitung. In einem vierten Schritt 208 wandelt eine Empfängereingangsschaltung das Eingangsstromsignal in eine Eingangsspannung um. In einem fünften Schritt 210 filtert die Empfängereingangsschaltung einen Wechselanteil aus der Eingangsspannung heraus. in einem sechsten Schritt 212 vergleicht eine Auswertelogik den Wechselanteil mit einer einstellbaren ersten Schwellenspannung, die aus einer Maximalspannung inklusive Toleranzwert besteht, wobei ein Unterschreiten der ersten Schwellenspannung eine intermittierende Impedanzerhöhung, d.h. eine dynamische Unterbrechung der ersten Leitung bedeutet. Das Verbindungsprüfgerät 100 kann mit dem Verfahren 200 ohne Einsatz eines teuren Präzisionsmessgeräts einfach und schnell dynamische Leitungsfehler in Form von intermittierenden Impedanzänderungen in einzelnen Leitungen aber auch in Kabelbäumen mit vielen Leitungen prüfen.

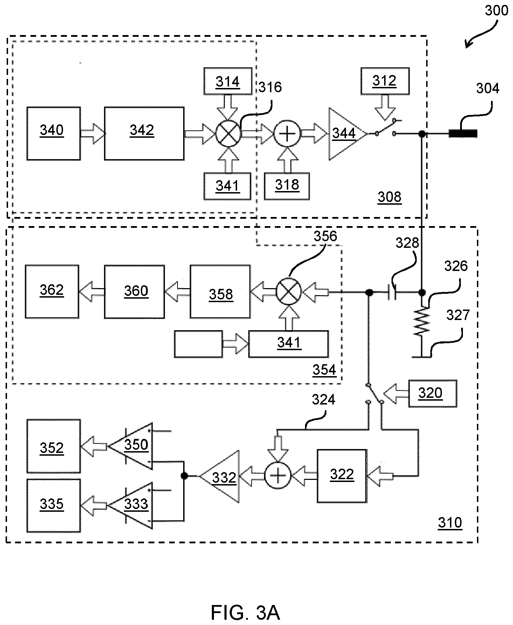

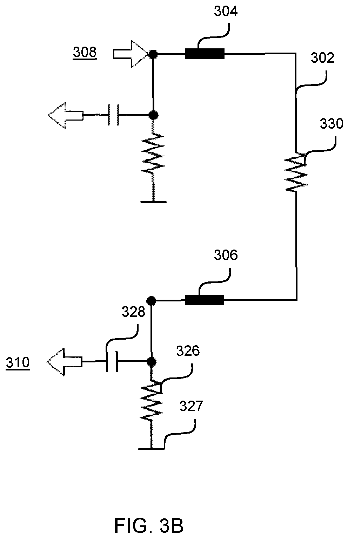

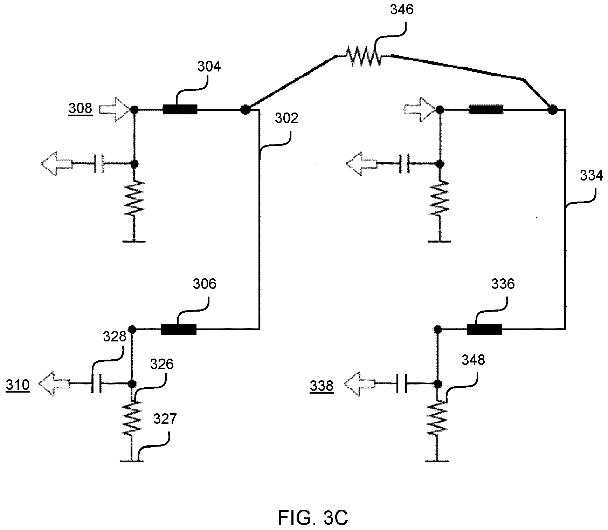

In der Figur 3A ist ein Verbindungsprüfgerät 300 gemäß eines weiteren Ausführungsbeispiels der Erfindung gezeigt. Das Verbindungsprüfgerät 300 prüft, ob während eines Tests eine Impedanzerhöhung in einem zu prüfenden ersten Einzelleiter 302, siehe Figur 3B, auftritt. Der zu prüfende erste Einzelleiter 302 gehört zu einem Kabelbaum und ist an wenigstens zwei Testpunkten 304, 306 des Verbindungsprüfberäts 300 angeschlossen. Der erste Testpunkt 304 ist als Sender 308 konfiguriert und sendet ein Prüfsignal an den ersten Testpunkt 304. Der zweite Testpunkt 306, siehe Figur 3B, ist als Empfänger 310 konfiguriert, indem sein eigenes Sendesignal mittels eines Sendeempfangsschalters 312 ausgeschaltet ist, und empfängt ein Empfangssignal vom zu prüfenden ersten Einzelleiter 302. Mittels eines Hochfrequenzschalters 314 wird ein Mischer 316 im Sender 308 so gesteuert, dass er ein von einer Gleichspannungsquelle 318 erzeugtes Gleichspannungssignal ausgibt. Ein Leistungstreiber 344 verstärkt das Gleichspannungssignal und führt es über den Sendeempfangsschalter 312 dem ersten Testpunkt 304 zu. Der Empfänger 310 umfasst einen Bypassschalter 320, eine Parallelschaltung mit einem Basisbandfilter 322 und einer Bypassleitung 324, wobei der Bypassschalter 320 so eingestellt ist, dass das Basisbandfilter 322 umgangen wird. So empfängt der Empfänger 310 ein Eingangsspannungssignal vom zu prüfenden ersten Einzelleiter 302 mit maximaler Bandbreite. Ein aus dem ersten Einzelleiter 302 austretender Strom fließt über einen Messwiderstand bzw. ein Abschlussimpedanz 326 zu einem Versorgungsspannungspotential 327 bzw. nach Masse und wandelt den Strom in das Eingangsspannungssignal, welches über einen zum Messwiderstand parallelgeschalteten Kondensator 328 von einer Gleichspannungskomponente getrennt wird. Das den Kondensator 328 passierende Signal repräsentiert den Wechselanteil des Eingangsspannungssignals. Steigt eine Leitungsimpedanz 330 des ersten Einzelleiters 302 kommt es zu einer Verringerung des Stroms und damit des Eingangsspannungssignals. Diese Eingangsspannungssignal bzw. dessen Wechselkomponente wird mit einem Eingangsverstärker 332 verstärkt und einem Unterbrechungskomparator 333 zugeführt, der die verstärkte Wechselkomponente mit einem einstellbaren Unterbrechungsspannungspegel vergleicht. Unterschreitet die verstärkte Wechselkomponente den Unterbrechungsspannungspegel wird ein binäres Ergebnissignal an eine Auswerteeinheit 335 ausgegeben, wobei eine 1 für eine Unterbrechung der Einzelleitung 302 steht und eine 0 für keine Unterbrechung der Einzelleitung 302. Ein Wechsel dieses binären Signals wird als dynamischer Unterbrechungsfehler in einem FPGA (englisch: field programmable gate array) gezählt. Das Verbindungsprüfgerät 300 kann gemäß eines weiteren Ausführungsbeispiels auch statische Leitungsfehler unterscheiden und zählen, wobei der Leitungsfehler noch vorliegt, es aber seit einem vorangegangen Wechsel des binären Signals eine bestimmte, programmierbare Zeit vergangen ist.

Gemäß eines weiteren Ausführungsbeispiels der Erfindung kann das Verbindungsprüfgerät 300 einen dynamischen Kurzschluss zwischen dem ersten und einem zweiten Einzelleiter 334 feststellen. Der zu prüfende erste Einzelleiter 302 ist wie oben beschrieben am ersten und zweiten Testpunkt 304, 306 bzw. an Sendeempfängern angeschlossen. Der Begriff Testpunkt kann dabei die Bedeutung eines Anschlussinterfaces für ein Leitungsende umfassen und/oder gleichbedeutend zum ganzen Sendempfänger verstanden werden. Damit ein Kurzschluss geprüft werden kann, ist wenigstens der zweite Einzelleiter 334, an einem dritten Testpunkt 336 eines zweiten Empfängers 338 bzw. eines weiteren Sendeempfängers, der den Empfänger 338 umfasst, anzuschließen. Der dritte Testpunkt 336 ist dabei entweder als reiner Empfänger 338 oder als Sendeempfänger konfiguriert. Jeder Sender besitzt eine eindeutige Adresse, diese ist Bestandteil eines im Sender erzeugten Basisbandsignals 340. Ein FPGA erzeugt dieses Basisbandsignal 340 und führt es einem NRZ (englisch non-return-to-zero) Kodierers 342 zu. Der NRZ Kodierer 342 kodiert Einsen und Nullen des Basisbandsignals 340 entsprechend in +1 für die logische 1 und -1 für die logische 0. Ein vom NRZ Kodierer 342 erzeugtes NRZ-Signal wird im Mischer 316 mit einem Trägersignal eines Oszillators 341 multipliziert. Ein so entstehendes Signal ist BPSK (englisch: binary phase shift keying) moduliert. Dieses BPSK modulierte Signal, auch als frame bezeichnet, wird für die Detektion einer nicht erlaubten elektrischen Verbindung, d.h. Kurzschluss, zweier Einzelleiter benötigt. Das BPSK-Signal lässt sich, wenn nur Impedanzerhöhungen detektiert werden, über den Hochfrequenzschalter 314 deaktivieren, so dass der Sender 308 ein Gleichspannungssignal erzeugt. Ist der Hochfrequenzschalter 314 aktiviert, wird das BPSK modulierte Signal permanent hintereinander als kontinuierlicher Datenstrom vom Sender 308 ausgegeben.

Eine Frequenz $f_c$ des Trägersignals wird so gewählt, dass gilt:

$$\lambda = 0,66 \cdot \frac{c_0}{f_c} \gg 2 \cdot L$$

wobei

λ: Wellenlänge der Frequenz des Trägersignals
$c_0$: Lichtgeschwindigkeit in Vakuum
$f_c$: Frequenz des Trägersignals
L: maximale Länge der Einzelleitung

Durch das Verhältnis zwischen Trägerfrequenz und Länge der Leitung ist sichergestellt, dass sich Signalpegel innerhalb eines frames der an den Testpunkten 304, 306, 336 angeschlossenen Leitungen 302, 334, unterscheiden.
Eine logische 1 ist am ersten Testpunkt 304 definiert als: $s_n(t) = A \cdot cos(2\pi f_c t) + s_2$ Eine logische 0 ist am ersten Testpunkt 304 definiert als: $s_n(t) = A \cdot cos(2\pi f_c t + \pi) + s_2$
wobei:

A: maximale Amplitude des Trägersignals
$f_c$: Frequenz des Trägersignals
$s_2$: Gleichspannungssignal der Gleichspannungsquelle 18, das als Gleichspannungsoffset wirkt

Der Gleichspannungsoffset bewirkt ein moduliertes Gleichspannung, das über den Leistungstreiber 344 und den aktivierten Sendeempfangsschalter 312 an den ersten Testpunkt 304 geführt wird.
Falls der erste Testpunkt 304 nicht als Sender benötigt wird, sondern als Empfänger, etwa bei einer Fehlersuche, wenn bei einem dauerhaften Kurzschluss zwei Sender in einen Stromkreis einspeisen, so wird das modulierte Gleichspannungssignal bzw. das Sendesignal durch den Sendeempfangsschalter 312 abgeschaltet.
Kommt es zu einer leitfähigen Verbindung 346 bzw. zu einem Kurzschluss zwischen dem ersten und zweiten Einzelleiter 302, 334, stellt sich aufgrund des Pegelunterschieds in den Einzelleitern 302, 334, ein Stromfluss zwischen den Einzelleitern 302, 334 ein. Dabei kommt es an den Abschlussimpedanzen 326 oder der Abschlussimpedanz 348, je nach dem an welcher ein niedrigerer Signalpegel anliegt, zu einer kurzzeitigen Pegelerhöhung, die in das Eingangssignal abgebildet wird. Der Bypassschalter 320 vor dem Basisbandfilter 322 ist deaktiviert, d.h. das Eingangssignal wird durch das Filter geführt und spektralen Anteile aus dem Basisband werden bedämpft, so dass sie nicht oder nur kurzzeitig von dem Unterbrechungskomparator 333 oder einem Kurzschlusskomparator 350 bewertet werden. Das vom Senderempfänger selbst erzeugte BPSK-Signal kann in dessen Empfänger in einem digitalen Filter entfernt werden, wobei Zeitpunkt und erwartete Adresse dem Filter bekannt sind. Kurzzeitig bedeutet dabei, dass eine verbleibende aktive Komparatorzeit ausreicht, um fremde spektrale Anteile aus dem zweiten Leiter zu erkennen. Das gefilterte Eingangssignal wird dem Unterbrechungskomparator zum Vergleich mit dem einstellbaren Unterbrechungsspannungspegel und dem Kurzschlusskomparator 350 zum Vergleich mit einem einstellbaren Kurzschlussspannungspegel zugeführt. Bei einer Überschreitung des Kurzschlussspannungspegels wird ein binäres Ergebnissignal an eine Auswerteeinheit 352 ausgegeben, wobei eine 1 für keinen Kurzschluss zwischen der ersten und zweiten Einzelleitung 302, 334 und eine 0 für einen Kurzschluss zwischen der ersten und zweiten Einzelleitung 302, 334 steht. Dieses binäre Ergebnissignal wird als dynamischer Kurzschlussfehler im FPGA gezählt. Der erste und zweite Empfänger 310, 338 weisen jeweils einen BPSK-Demodulator 354 auf. Der BPSK-Demodulator 354 umfasst einen Abwärtsmischer 356, der das Eingangssignal und das Trägersignal empfängt und das Eingangssignal um die Frequenz des Trägersignals zu einem Abwärtsmischerausgangssignal herabsetzt; einen Integrator 358, der mit dem Abwärtsmischer 356 verbunden ist, das Abwärtsmischerausgangssignal empfängt, über eine Bitperiode integriert und als Integratorausgangssignal ausgibt; einen Schwellwentscheider 360, der mit dem Integrator 358 verbunden ist, das Integratorausgangssignal empfängt, in einer Bitmitte mit einem Entscheidungsschwellwert vergleicht und ein Digitalsignal ausgibt, und eine Basisband-Auswerteeinheit 362, die mit dem Schwellwertentscheider 360 verbunden ist, das Digitalsignal empfängt und auswertet ob und gegebenenfalls welche Adresse im Digitalsignal enthalten ist. Der BPSK-Demodulator 354 kann mittels Adresse das Empfangssignal eindeutig dem Sendesignal des Senders oder im Fall mehrerer Sender dem Sendesignal eines bestimmten der mehreren Sender zuordnen.

BEZUGSZEICHENLISTE

| | |
|---|---|
| 100 | Verbindungsprüfgerät |
| 102 | Sender |
| 104 | Empfänger |
| 106 | Prüfsignalgenerator |
| 108 | Erster Testpunkt |
| 110 | Erste Leitung |
| 112 | Zweiter Testpunkt |
| 114 | Empfängereingangsschaltung |
| 116 | Auswertelogik |
| 200 | Prüfverfahren |
| 202, 204, 206, 208, 210, 212 | Schritte |
| 300 | Verbindungsprüfgerät |
| 302 | Erster Einzelleiter |
| 304 | Erster Testpunkt |
| 306 | Zweiter Testpunkt |
| 308 | Sender |
| 310 | Empfänger |
| 312 | Sendeempfangsschalter |
| 314 | Hochfrequenzschalter |
| 316 | Mischer |
| 318 | Gleichspannungsquelle |
| 320 | Bypassschalter |
| 322 | Basisbandfilter |
| 324 | Bypassleitung |
| 326 | Messwiderstand |
| 327 | Versorgungsspannungspotential |
| 328 | Kondensator |
| 330 | Leitungsimpedanz |
| 332 | Eingangsverstärker |
| 333 | Unterbrechungskomparator |
| 334 | Zweiter Einzelleiter |
| 335 | Auswerteeinheit |
| 336 | Dritter Testpunkt |
| 338 | Zweiter Empfänger |
| 340 | Basisbandsignal |
| 341 | Oszillator |
| 342 | NRZ Kodierer |
| 344 | Leistungstreiber |
| 346 | Leitfähige Verbindung |
| 348 | Abschlussimpedanz |
| 350 | Kurzschlusskomparator |
| 352 | Auswerteeinheit |
| 354 | BPSK-Demodulator |
| 356 | Abwärtsmischer |
| 358 | Integrator |
| 360 | Schwellwertentscheider |
| 362 | Basisband-Auswerteeinheit |

**Patentansprüche**

1. Verbindungsprüfgerät (100; 300) zum Prüfen einer intermittierenden Impedanzänderung in einer ersten und/oder zweiten Leitung (110; 302, 334) umfassend:

   einen Sender (102; 308) mit
   einem Prüfsignalgenerator (106) zum Erzeugen eines Prüfsignals und
   einem ersten Testpunkt (108; 304) zum Anschluss der ersten (110; 302) oder zweiten Leitung (334), wobei der Prüfsignalgenerator (106) das Prüfsignal über den ersten Testpunkt (108; 304) der ersten (110; 302) oder zweiten Leitung (334) zuführt, und
   einen ersten Empfänger (104; 310, 338) mit
   einem zweiten Testpunkt (114) zum Anschluss der ersten (110; 302) oder zweiten Leitung (334) und
   einer Empfängereingangsschaltung (114; 326, 328), die über den zweiten Testpunkt (112; 306, 336) ein Empfangssignal aus der ersten (110; 302) oder zweiten Leitung (334) empfängt, und
   eine Auswertelogik (116), die mit der Empfängereingangsschaltung (114; 326, 328) verbunden ist und die das Eingangssignal mit einem Schwellwert vergleicht, um daraus eine intermittierende Impedanzänderung in der ersten (110; 302) und/oder zweiten Leitung (334) festzustellen,
   **dadurch gekennzeichnet, dass**
   die Auswertelogik (116) einen zweiten Komparator (350) umfasst, der das Eingangssignal mit einem zweiten Schwellwert vergleicht, wobei eine Überschreitung des zweiten Schwellwerts einen Kurzschluss zwischen der ersten 110; 302) und zweiten Leitung (334) bedeutet.

2. Verbindungsprüfgerät (100; 300) nach Anspruch 1
   **dadurch gekennzeichnet, dass**
   die Empfängereingangsschaltung (114; 326, 328) ein RC-Glied (114; 326, 328) umfasst, das ein Wechselspannungssignal vom zweiten Testpunkt (112; 306, 336) abgreift, das das Eingangssignal bildet.

3. Verbindungsprüfgerät (100; 300) nach Anspruch 1 oder 2
   **dadurch gekennzeichnet, dass**
   die Auswertelogik (116) wenigstens einen ersten Komparator (333; 350) umfasst, der das Eingangssignal mit einem einstellbaren ersten Schwellwert vergleicht, wobei eine Unterschreitung des ersten Schwellwerts eine Unterbrechung in der ersten (110; 302) oder zweiten Leitung (334) bedeutet.

4. Verbindungsprüfgerät (100; 300) nach einem der vorhergehenden Ansprüche
   **dadurch gekennzeichnet, dass**
   das Prüfsignal eine Gleichspannung umfasst.

5. Verbindungsprüfgerät (100; 300) nach einem der vorhergehenden Ansprüche
   **dadurch gekennzeichnet, dass**
   der Prüfsignalgenerator (106) einen Identifikationssignalgenerator umfasst, der ein eindeutiges Identifikationssignal erzeugt.

6. Verbindungsprüfgerät (100; 300) nach Anspruch 5
   **dadurch gekennzeichnet, dass**
   der Prüfsignalgenerator (106) einen Mischer (316) und einen Oszillator (341) umfasst, wobei der Mischer (316) das Identifikationssignal mit einem vom Oszillator (341) erzeugten Trägersignal zu einem, insbesondere BPSKmodulierten, Hochfrequenzsignal mischt.

7. Verbindungsprüfgerät (100; 300) nach Anspruch 5 oder 6
   **dadurch gekennzeichnet, dass**
   der Empfänger (104; 310; 338) einen Identifikationssignal-Demodulator (354) umfasst.

8. Verbindungsprüfgerät (100; 300) nach einem der Ansprüche 5 bis 7
   **dadurch gekennzeichnet, dass**
   der Empfänger (104; 310, 338) ein Filter (322) umfasst, das zwischen das RC-Glied (114; 326, 328) und die Auswertelogik (116) geschaltet ist.

9. Verbindungsprüfgerät (100; 300) nach einem der Ansprüche 5 bis 8

**dadurch gekennzeichnet, dass**
eine Frequenz des Trägersignals in Abhängigkeit einer Länge der ersten (110; 302) oder zweiten Leitung (334) gewählt ist.

10. Verbindungsprüfgerät (100; 300) nach einem der Ansprüche 6 bis 9
**dadurch gekennzeichnet, dass**
der Prüfsignalgenerator (106) das Hochfrequenzsignal mit der Gleichspannung summiert und daraus das Prüfsignal bildet.

11. Verbindungsprüfgerät (100; 300) nach einem der vorhergehenden Ansprüche
**dadurch gekennzeichnet, dass**
der Sender einen ersten Schalter (312) umfasst, der den Prüfsignalgenerator (106) vom ersten Testpunkt (108; 304) wahlweise entkoppelt.

12. Verbindungsprüfgerät (100; 300) nach einem der vorhergehenden Ansprüche
**dadurch gekennzeichnet, dass**
das Verbindungsprüfgerät (100; 300) einen zweiten Empfänger (338) zum Prüfen der ersten und/oder zweiten Leitung (110; 302, 334) umfasst.

13. Verfahren (200) zu Prüfen einer intermittierenden Impedanzänderung in einer ersten und/oder zweiten Leitung, das die folgenden Schritte umfasst:

Senden (202) eines Prüfsignals mittels eines Senders in ein erstes Leitungsende der ersten oder zweiten Leitung;
Beaufschlagen (204) der ersten oder zweiten Leitung mit Umwelteinflüssen, die eine Impedanz der erste und/oder zweiten Leitung verändern;
Empfangen (206) eines Eingangssignals mit einem Empfänger von einem zweiten Leitungsende der ersten oder zweiten Leitung;
Wandeln (208) des Eingangssignals mit einer Empfängereingangsschaltung in ein Spannungssignal;
Filtern (210) des Spannungssignals mit der Empfängereingangsschaltung zu einem Wechselanteil des Eingangssignals;
Vergleichen (212) des Wechselanteils mittels einer Auswertelogik mit einem ersten Schwellwert, um daraus eine intermittierende Impedanzänderung in der ersten und/oder zweiten Leitung festzustellen und Vergleichen des Wechselanteils mittels der Auswertelogik mit einem zweiten Schwellwert, um daraus einen Kurzschluss in der ersten und zweiten Leitung festzustellen.

**Claims**

1. A connection testing device (100; 300) for testing an intermittent impedance change in a first and/or second line (110; 302, 334), comprising:

a transmitter (102; 308) having
a test signal generator (106) for producing a test signal and
a first test point (108; 304) for joining the first (110; 302) or second line (334), wherein the test signal generator (106) supplies the test signal via the first test point (108; 304) to the first (110; 302) or second line (334), and
a first receiver (104; 310, 338) having
a second test point (114) for joining the first (110; 302) or second line (334) and
a receiver input circuit (114; 326, 328) which receives a received signal from the first (110; 302) or second line (334) via the second test point (112; 306, 336), and
an evaluation logic (116) which is connected to the receiver input circuit (114; 326, 328) and which compares the input signal with a threshold value in order to establish an intermittent impedance change in the first (110; 302) and/or second line (334) therefrom,
**characterized in that**
the evaluation logic (116) comprises a second comparator (350) which compares the input signal with a second threshold value, wherein exceeding the second threshold value denotes a short circuit between the first (110; 302) and the second line (334).

2. The connection testing device (100; 300) according to Claim 1,

**characterized in that**
the receiver input circuit (114; 326, 328) comprises an RC element (114; 326, 328) which picks up an AC voltage signal from the second test point (112; 306, 336), which forms the input signal.

3. The connection testing device (100; 300) according to Claim 1 or 2,
**characterized in that**
the evaluation logic (116) comprises at least a first comparator (333; 350) which compares the input signal with an adjustable first threshold value, wherein falling short of the first threshold value denotes a break in the first (110; 302) or the second line (334).

4. The connection testing device (100; 300) according to any one of the preceding claims,
**characterized in that**
the test signal comprises a DC voltage.

5. The connection testing device (100; 300) according to any one of the preceding claims,
**characterized in that**
the test signal generator (106) comprises an identification signal generator which produces a unique identification signal.

6. The connection testing device (100; 300) according to Claim 5,
**characterized in that**
the test signal generator (106) comprises a mixer (316) and an oscillator (341), wherein the mixer (316) mixes the identification signal with a carrier signal produced by the oscillator (341) to form an in particular BPSK-modulated, high-frequency signal.

7. The connection testing device (100; 300) according to Claim 5 or 6,
**characterized in that**
the receiver (104; 310; 338) comprises an identification signal demodulator (354).

8. The connection testing device (100; 300) according to any one of Claims 5 to 7,
**characterized in that**
the receiver (104; 310, 338) comprises a filter (322) which is connected between the RC element (114; 326, 328) and the evaluation logic (116).

9. The connection testing device (100; 300) according to any one of Claims 5 to 8,
**characterized in that**
a frequency of the carrier signal is selected as a function of a length of the first (110; 302) or second line (334).

10. The connection testing device (100; 300) according to any one of Claims 6 to 9, **characterized in that**
the test signal generator (106) sums the high-frequency signal with the DC voltage and forms the test signal therefrom.

11. The connection testing device (100; 300) according to any one of the preceding claims,
**characterized in that**
the transmitter comprises a first switch (312) which optionally decouples the test signal generator (106) from the first test point (108; 304).

12. The connection testing device (100; 300) according to any one of the preceding claims,
**characterized in that**
the connection testing device (100; 300) comprises a second receiver (338) for testing the first and/or second line (110; 302, 334).

13. A method (200) for testing an intermittent impedance change in a first and/or second line, comprising the following steps:

transmitting (202) a test signal by means of a transmitter into a first line end of the first or second line;
subjecting (204) the first or second line to environmental influences which alter an impedance of the first and/or second line;
receiving (206) an input signal with a receiver from a second line end of the first or second line;

converting (208) the input signal with a receiver input circuit into a voltage signal;
filtering (210) the voltage signal with the receiver input circuit to obtain an AC portion of the input signal;
comparing (212) the AC portion by means of an evaluation logic with a first threshold value in order to establish an intermittent impedance change in the first and/or second line therefrom and comparing the AC portion by means of the evaluation logic with a second threshold value in order to establish a short circuit in the first and second line therefrom.

**Revendications**

1.  Appareil de test de connexion (100 ; 300) pour tester une modification d'impédance intermittente dans une première et/ou une deuxième ligne (110 ; 302, 334), comprenant :

    un émetteur (102 ; 308) avec
    un générateur de signal de test (106) pour générer un signal de test, et
    un premier point de test (108 ; 304) pour raccorder la première (110 ; 302) ou la deuxième ligne (334), le générateur de signal de test (106) amenant le signal de test à la première (110 ; 302) ou à la deuxième ligne (334) via le premier point de test (108 ; 304), et
    un premier récepteur (104 ; 310, 338) avec
    un deuxième point de test (114) pour raccorder la première (110 ; 302) ou la deuxième ligne (334) et
    un circuit d'entrée de récepteur (114 ; 326, 328) qui reçoit un signal de réception à partir de la première (110 ; 302) ou de la deuxième ligne (334) via le deuxième point de test (112 ; 306, 336), et
    une logique d'évaluation (116) qui est connectée au circuit d'entrée de récepteur (114 ; 326, 328) et qui compare le signal d'entrée à une valeur de seuil pour en déduire une modification d'impédance intermittente dans la première (110 ; 302) et/ou la deuxième ligne (334),
    **caractérisé en ce que**
    la logique d'évaluation (116) comprend un deuxième comparateur (350) qui compare le signal d'entrée à une deuxième valeur de seuil, un dépassement de la deuxième valeur de seuil signifiant un court-circuit entre la première (110 ; 302) et la deuxième ligne (334).

2.  Appareil de test de connexion (100 ; 300) selon la revendication 1,
    **caractérisé en ce que**
    le circuit d'entrée de récepteur (114 ; 326, 328) comprend un élément RC (114 ; 326, 328) qui prélève un signal de tension alternative à partir du deuxième point de test (112 ; 306, 336), qui forme le signal d'entrée.

3.  Appareil de test de connexion (100 ; 300) selon la revendication 1 ou 2,
    **caractérisé en ce que**
    la logique d'évaluation (116) comprend au moins un premier comparateur (333 ; 350) qui compare le signal d'entrée à une première valeur de seuil réglable, un sous-dépassement de la première valeur de seuil signifiant une interruption dans la première (110 ; 302) ou la deuxième ligne (334).

4.  Appareil de test de connexion (100 ; 300) selon l'une quelconque des revendications précédentes,
    **caractérisé en ce que**
    le signal de test comprend une tension continue.

5.  Appareil de test de connexion (100 ; 300) selon l'une quelconque des revendications précédentes,
    **caractérisé en ce que**
    le générateur de signal de test (106) comprend un générateur de signal d'identification qui génère un signal d'identification unique.

6.  Appareil de test de connexion (100 ; 300) selon la revendication 5,
    **caractérisé en ce que**
    le générateur de signal de test (106) comprend un mélangeur (316) et un oscillateur (341), le mélangeur (316) mélangeant le signal d'identification avec un signal porteur généré par l'oscillateur (341) pour former un signal haute fréquence, notamment modulé en BPSK.

7.  Appareil de test de connexion (100 ; 300) selon la revendication 5 ou 6,
    **caractérisé en ce que**

le récepteur (104 ; 310 ; 338) comprend un démodulateur de signal d'identification (354).

8. Appareil de test de connexion (100 ; 300) selon l'une quelconque des revendications 5 à 7,
**caractérisé en ce que**
le récepteur (104 ; 310, 338) comprend un filtre (322) connecté entre l'élément RC (114 ; 326, 328) et la logique d'évaluation (116).

9. Appareil de test de connexion (100 ; 300) selon l'une quelconque des revendications 5 à 8,
**caractérisé en ce**
**qu'**une fréquence du signal porteur est choisie en fonction d'une longueur de la première (110 ; 302) ou de la deuxième ligne (334).

10. Appareil de test de connexion (100 ; 300) selon l'une quelconque des revendications 6 à 9,
**caractérisé en ce que**
le générateur de signal de test (106) additionne le signal haute fréquence avec la tension continue et forme le signal de test à partir de cela.

11. Appareil de test de connexion (100 ; 300) selon l'une quelconque des revendications précédentes,
**caractérisé en ce que**
l'émetteur comprend un premier commutateur (312) qui découple sélectivement le générateur de signal de test (106) du premier point de test (108 ; 304).

12. Appareil de test de connexion (100 ; 300) selon l'une quelconque des revendications précédentes,
**caractérisé en ce que**
l'appareil de test de connexion (100 ; 300) comprend un deuxième récepteur (338) pour tester la première et/ou la deuxième ligne (110 ; 302, 334).

13. Procédé (200) de test d'une modification d'impédance intermittente dans une première et/ou une deuxième ligne, comprenant les étapes suivantes :

l'envoi (202) d'un signal de test au moyen d'un émetteur dans une première extrémité de ligne de la première ou de la deuxième ligne ;
la soumission (204) de la première ou de la deuxième ligne à des influences environnementales qui modifient une impédance de la première et/ou de la deuxième ligne ;
la réception (206) d'un signal d'entrée avec un récepteur à partir d'une deuxième extrémité de ligne de la première ou de la deuxième ligne ;
la conversion (208) du signal d'entrée en un signal de tension avec un circuit d'entrée de récepteur ;
la filtration (210) du signal de tension avec le circuit d'entrée de récepteur en une partie alternative du signal d'entrée ;
la comparaison (212), au moyen d'une logique d'évaluation, de la partie alternative à une première valeur de seuil pour en déduire une modification d'impédance intermittente dans la première et/ou la deuxième ligne, et la comparaison, au moyen de la logique d'évaluation, de la partie alternative à une deuxième valeur de seuil pour en déduire un court-circuit dans la première et la deuxième ligne.

FIG. 1

FIG. 2

FIG. 3A

FIG. 3B

FIG. 3C

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- GB 2529456 A
- GB 2531268 A
- US 2010268507 A1
- US 5744967 A
- WO 2020125996 A1
- US 2019257882 A1
- CN 103983884 A
- US 2019383873 A1